# EUROPEAN PATENT SPECIFICATION

(11) **EP 2 683 791 B1**
(45) Date of publication and mention of the grant of the patent: **29.06.2016**
(21) Application number: 12755590.2
(22) Date of filing: 08.03.2012
(51) Int. Cl.: C09K 11/80, H01L 33/50

(54) **YELLOW-GREEN TO YELLOW-EMITTING PHOSPHORS BASED ON HALOGENATED-ALUMINATES**
GELBGRÜNES BIS GELBES LICHT EMITTIERENDER LEUCHTSTOFF AUF BASIS HALOGENIERTER ALUMINATE
LUMINOPHORE ÉMETTANT DU JAUNE VERT AU JAUNE À BASE D'ALUMINATES HALOGÉNÉS

(30) Priority: 08.03.2011 US 201161450310 P
(43) Date of publication of application: 15.01.2014
(73) Proprietor: Intematix Corporation, Fremont CA 94538 (US)
(72) Inventor: LI, Yi-Qun, Danville, California 94506 (US); GU, Jingtao, Shanghai (CN); JIA, Zhankun, Changchun (CN); CHENG, Shifan, Dublin, California 94568 (US)
(74) Representative: Birdi, Sandeep Singh
(86) International application number: PCT/US2012/028338
(87) International publication number: WO 2012/122401

(56) References cited:
- WO-A2-2004/084261
- US-A- 4 762 639
- US-A1- 2004 000 862
- US-A1- 2004 256 974
- US-A1- 2005 199 897
- US-A1- 2006 158 097
- US-A1- 2008 018 235
- US-A1- 2008 231 171
- US-A1- 2009 212 314
- US-A1- 2009 218 585
- US-A1- 2010 085 728
- US-A1- 2010 308 712
- US-A1- 2011 050 086
- WU J L ET AL: "SPECTRAL PROPERTIES OF VARIOUS CERIUM DOPED GARNET PHOSPHORS FOR APPLICATION IN WHITE GAN-BASED LEDS", MATERIALS RESEARCH SOCIETY SYMPOSIUM PROCEEDINGS; [MATERIALS RESEARCH SOCIETY SYMPOSIUM PROCEEDINGS], MATERIALS RESEARCH SOCIETY, PITTSBURG, PA; US, vol. 658, 1 January 2001 (2001-01-01), pages GG11.8.1-GG11.8.6, XP009036120, ISBN: 978-1-55899-828-5

## Description

### BACKGROUND OF THE INVENTION

### Field of the Invention

Embodiments of the present disclosure are directed in to yellow-green to yellow-emitting phosphors based on halogenated aluminates. Such phosphors are applicable to a number of different technologic areas, including general lighting systems, white light illumination systems based on white LEDs, signal lights; indicator lights, etc., as well as display applications such as display backlighting, plasma display panels, LED-based display panels, and the like.

### Description of the Related Art

Embodiments of the present invention are directed to halogenated aluminate-based phosphors that, when activated by cerium, and when doped with the rare earths lutetium and a second rare earth, which may be gadolinium, emit visible light in the yellow-green to yellow portion of the electromagnetic spectrum. The phrase "visible light in the yellow-green to yellow portion of the electromagnetic spectrum" is defined to mean light having a peak emission wavelength of about 550 nm to about 600 nm. Such phosphors may be used in commercial markets where white light is generated using so-called "white light LEDs," noting as an aside that this term is somewhat of a misnomer, since light emitting diodes emit light of a specific monochromatic color and not a combination of wavelengths perceived as white by the human eye. The term is nonetheless entrenched in the lexicon of the lighting industry.

Historically, YAG:Ce (yittrium aluminate garnet activated with cerium) has been used to supply the yellow component of the light in the lighting systems mentioned above. In comparison to other phosphor hosts, particularly those based on the silicates, sulphates, nitridosilicates, and oxo-nitridosilicates, YAG:Ce has a relatively high absorption efficiency when excited by blue light, is stable in high temperature and humidity environments, and has a high quantum efficiency (QE>95%), all the while displaying a broad emission spectrum.

One disadvantage to using a YAG:Ce based phosphor, other than inadequate color rendering in some situations, is that the peak emission of this phosphor is too long, that is to say, too deep towards the orange or red for use as a luminescent source in, for example, a backlighting application. An alternative to YAG:Ce is the cerium doped Lu₃Al₅0₁₂ compound (LAG:Ce), which has the same crystalline structure as YAG:Ce, a similar temperature and humidity stability as the yttrium-based compound, and likewise quantum efficiency. Despite these similarities, LAG:Ce exhibits a different peak emission wavelength than its YAG counterpart; in the lutetium case, this peak wavelength is at about 540 nm. This emission wavelength is still not short enough, however, to be ideal for certain applications such as backlighting applications, and general lighting applications, where appropriate.

WO/2012/009455 discloses green-emitting, garnet-based phosphors having the formula (Lu_{1-a-b-c}YₐTb_{b}A_{c})₃(Al_{1-d}B_{d})₅(O₁₋ₑCₑ)₁₂:Ce,Eu, where A is selected from the group consisting of Mg, Sr, Ca, and Ba; B is selected from the group consisting of Ga and In; C is selected from the group consisting of F, Cl, and Br; and 0≤a≤1; 0≤b≤1; 0≤c≤0.5; 0≤d≤1; and 0≤e≤0.2. Their peak emission wavelength may lie between about 500 nm and 540 nm; in one embodiment, the phosphor (Lu,Y,A)₃Al₅(O,F,Cl)₁₂:Eu²⁺ has an emission at 540 nm. The FWHM of the emission peak lies between 80 nm and 150 nm. The green garnet phosphors may be combined with a red-emitting, nitride-based phosphor such as CaAlSiN₃ to produce white light.

J.L. WU et al. disclose in "SPECTRAL PROPERTIES OF VARIOUS CERIUM DOPED GARNET PHOSPHORS FOR APPLICATION IN WHITE GAN-BASED LEDS", MATERIALS RESEARCH SOCIETY SYMPOSIUM PROCEEDINGS; vol. 658, pages GG11.8.1-GG11.8.6, cerium-activated lutetium aluminate phosphors. In particular phosphors with the general formula Gd₃₋ₓLuₓAl_{5-y}Ga_{y}O₁₂:Ce such as (Lu_{0.6}Gd_{0.3}Ce_{0.003})₃Al₅O₁₂ are disclosed with peak emission wavelength of about 565 nm are presented.

### SUMMARY OF THE INVENTION

Embodiments of the present disclosure are directed to yellow-green and yellow-emitting aluminate based phosphors for use in white LEDs, general lighting, and LED and backlighting displays.

According to a first aspect of the present invention, there is provided a yellow-green to yellow-emitting halogenated lutetium aluminate phosphor having the formula: (Lu_{1-x-y}AₓCe_{y})₃B_{z}Al₅O₁₂C_{2z}, where A is Gd; B is at least one of Sr and Ba; C is at least one of F, Cl, Br, and I; 0 < x ≤ 0.5; 0.001 ≤ y ≤ 0.2; and 0.001 ≤ z ≤ 0.5; wherein said phosphor is configured to emit light having a peak emission wavelength ranging from 550 nm to 600 nm.

According to another aspect of the present invention, there is contemplated a white LED comprising: a radiation source configured to provide radiation having a wavelength greater than about 280 nm; a cerium-activated, yellow-green to yellow-emitting halogenated lutetium aluminate phosphor as defined herein; and at least one of a red-emitting phosphor or a yellow-emitting phosphor.

There is also described a cerium-activated, yellow-green to yellow-emitting aluminate phosphor which comprises the rare earth lutetium, at least one alkaline earth metal, aluminum, oxygen, at least one halogen, and at least one rare earth element other than lutetium, wherein the phosphor is configured to absorb excitation radiation having a wavelength ranging from about 380 nm to about 480 nm, and to emit light having a peak emission wavelength ranging from about 550 nm to about 600 nm.

There is also described a yellow-green to yellow-emitting aluminate phosphor which comprises a halogenated aluminate, an M²⁺X₂ additive, and a cerium activator; where M²⁺ is a divalent, alkaline earth metal selected from the group consisting of Mg, Sr, Ca, and Ba; X is a halogen selected from the group consisting of F, Cl, Br, and I; and wherein the M²⁺X₂ additive is included in the phosphor in amounts ranging up to about 5 wt%, the upper endpoint inclusive.

There is also described a yellow-green to yellow-emitting phosphor comprises a halogenated aluminate having the formula A₃BₓAl₅O₁₂C_{y}:C³⁺, where A is at least one of Lu, La, Sc, Gd, or Tb; B is at least one of Mg, Sr, Ca, or Ba; C is at least one of F, Cl, Br, or I; and y is about 2x, although y may be less than 2x by amounts (stoichiometrically) of up to 5, 10, 25, and 50 percent. The yellow-green to yellow-emitting halogenated aluminate phosphor comprises an aluminate configured to absorb excitation radiation having a wavelength ranging from about 420 nm to about 480 nm, and to emit light having a peak emission wavelength ranging from about 550 nm to about 600 nm.

In another embodiment of the present invention, the yellow-green to yellow-emitting halogenated aluminate phosphor has the formula: (Lu_{i-x-y}AₓCe_{y})₃B_{z}Al₅O₁₂C_{2z}; where A is Gd; B is at least one of Sr and Ba; C is at least one of F, C, Br, and I; 0 ≤ x ≤ 0.5; 0.001 ≤ y ≤ 0.2; and 0.001 ≤ z ≤ 0.5.

There are also described a general lighting or white LEDs, which comprise a radiation source configured to provide radiation having a wavelength greater than about 280 nm; a cerium-activated, yellow-green to yellow-emitting aluminate phosphor comprising the rare earth lutetium, at least one alkaline earth metal, aluminum, oxygen, at least one halogen, and at least one rare earth element other than lutetium, wherein the phosphor is configured to absorb excitation radiation having a wavelength ranging from about 380 nm to about 480 nm, and to emit light having a peak emission wavelength ranging from about 550 nm to about 600 nm. It includes at least one of a red-emitting phosphor or a yellow-emitting phosphor. There are also described alternative general lighting or white LEDs which may comprise: a radiation source configured to provide radiation having a wavelength greater than about 280 nm; a yellow-green to yellow-emitting phosphor comprising a halogenated aluminate having the formula A₃BₓAl₅O₁₂Cy:Ce³⁺, where A is at least one of Lu, La, Sc, Gd, or Tb; B is at least one of Mg, Sr, Ca, or Ba; C is at least one of F, Cl, Br, or I; where y is about equal to or less than 2x; and at least one of a red-emitting phosphor or a yellow-emitting phosphor.

### BRIEF DESCRIPTION OF THE DRAWING

FIG. 1 shows the SEM morphology of Lu_{2.91}Ce_{0.09}Al₅O₁₂ with different MgF₂ additive concentrations, illustrating that particle sizes become larger and more homogeneous as the amount of the MgF₂ additive is increased;
FIG. 2 is a series of x-ray diffraction (XRD) patterns of Y_{2.91}Ce_{0.09}Al₅O₁₂ phosphors with different MgF₂ additive concentrations;
FIG. 3 is a series x-ray diffraction (XRD) patterns of Lu_{2.91}Ce_{0.09}Al₅O₁₂ phosphors with different MgF₂ additive concentrations;
FIG. 4 is a series of the x-ray diffraction (XRD) patterns of Lu_{2.91}Ce_{0.09}Al₅O₁₂ phosphors having a 5 wt% MgF₂ additive and a 5 wt% SrF₂ additive;
FIG. 5 is the emission spectra of a series of Y_{2.91}Ce_{0.09}Al₅O₁₂ phosphors with different levels of MgF₂ additive, the emission spectra obtained by exciting the phosphors with a blue LED;
FIG. 6 is the normalized emission spectra of a series of Lu_{2.91}Ce_{0.09}Al₅O₁₂ phosphors with different MgF₂ additive concentrations under blue LED excitation;
FIG. 7 is the emission spectra of Lu_{2.91}Ce_{0.09}Al₅O₁₂ phosphors with different MgF₂ additive under blue LED excitation;
FIG. 8 is the normalized emission spectra of Lu_{2.91}Ce_{0.09}Al₅O₁₂ phosphors with different MgF₂ additive under blue LED excitation; the results show that the emission peak of Lu_{2.91}Ce_{0.09}Al₅O₁₂ shifts to short wavelength with certain amount of MgF₂ additive, and that the greater the amount of the MgF₂ additive, the shorter emission peak wavelength;
FIG. 9 is a normalized emission spectra of a Lu_{2.91}Ce_{0.09}Al₅O₁₂ phosphor with 5 wt% MgF₂ and 5 wt% SrF₂ additives where the phosphor has been excited with a blue LED; the results are compared with a control sample that contains no halogenated salts as an additive; the results illustrate that the emission peak shifts to shorter wavelengths with the MgF₂ synthesized compound than it does for the Surf2 synthesized compound;
FIG. 10 shows how the emission wavelength of a series of Lu_{2.91}Ce_{0.09}Al₅O₁₂ phosphors decreases as the concentration of an SrF₂ additive is increased;
FIG. 11 is the normalized excitation spectra of a series of Lu_{2.91}Ce_{0.09}Al₅O₁₂ phosphors with different MgF₂ additive concentrations, showing that the excitation spectra becomes more narrow when the MgF₂ additive concentration is increased;
FIG. 12 shows the temperature dependence of an exemplary Lu_{2.91}Ce_{0.09}Al₅O₁₂ phosphor with a 5wt% MgF₂ additive;
FIG. 13 shows the spectra of a white LED that includes an green-emitting, aluminate-based phosphor having the formula Lu_{2.91}Ce_{0.09}Al₅O₁₂ with 5 wt% SrF₂ additive; the white LED also includes a red phosphor having the formula (Ca_{0.2}Sr_{0.8})AlSiN₃:EU²⁺, and when both green and red phosphors are excited with an InGaN LED emitting blue light, the resulting white light had the color properties CIE x = 0.24, and CIE y = 0.20.
FIG. 14 is the spectra of a white LED with the following components: a blue InGaN LED, a green garnet having the formula Lu_{2.91}Ce_{0.09}Al₅O₁₂ with either 3 or 5 wt% additives, a red nitride having the formula (Ca_{0.2}Sr_{0.8})AlSiN₃:Eu²⁺ or a silicate having the formula (Sr_{0.5}Ba_{0.5})₂SiO₄:Eu²⁺, wherein the white light has the color coordinates CIE (x=0.3,y=0.3).
FIG. 15 is the spectra of the white LED systems of FIG 14, in this instance measured at 3,000 K.
FIG. 16 is a table giving exemplary phosphors according to the general formula (Lu_{1-x-y}AₓCe_{y})₃B_{z}Al₅O₁₂C_{2z}, where A is Gd, B is either Ba or Sr, and C is F; the table also lists comparative CIE x and y coordinates of the emitted light; the peak emission wavelength in nm, relative intensities, and D50 particle size in microns.
FIGS. 17A-B shows that the peak emission wavelength of these halogenated aluminates ranged overall from about 550 nm to about 580 nm as the Gd level was increased, where the Ba level was fixed stoichiometrically at 0.15 for the Ba series, and where the Sr level was fixed stoichiometrically at 0.34; and

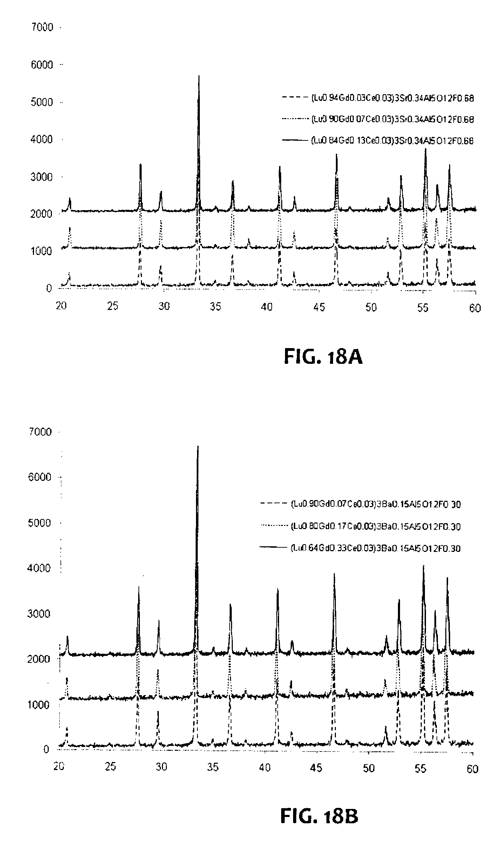

FIGS. 18A-B are the x-ray diffraction patterns of both the Ba series and the Sr series of phosphors whose luminosity data was depicted in FIGS. 17A-B.

### DETAILED DESCRIPTION OF THE INVENTION

An yttrium aluminum garnet compound activated with the rare earth cerium (YAG:Ce) has been, historically, one of the most common choices of phosphor material made if the desired application was either high power LED lighting, or cool white lighting of a non-specific, general nature. As one might expect, there is a requirement in general lighting for highly efficient components, both in the case of the LED chip supplying the blue light component of the resultant white light, and the excitation radiation for the phosphor, where the phosphor typically supplies the yellow/green constituent of the resulting product white light.

As discussed in the previous section of this disclosure, YAG:Ce demonstrates this desired high efficiency, having a quantum efficiency greater than about 95 percent, and it would therefore appear to be a difficult task to improve upon this number. But it is known in the art that the efficiency of an LED chip increases with a decrease in emission wavelength, and thus it would appear, in theory anyway, that the efficiency of a general lighting system will be enhanced if a phosphor paired with an LED chip emitting at shorter wavelengths may be excited by those shorter wavelengths. The problem with this strategy, unfortunately, is that the emission efficiency of a YAG:Ce phosphor decreases when the wavelength of its blue excitation radiation is reduced to a level below about 460 nm.

The repercussions of this are, of course, that YAG:Ce should really only be paired with an LED chip having an emission wavelength no less than about 450 to 460 nm. But it is also known in the art that photon energies of the phosphor's excitation radiation depend strongly on the structure of the anionic polyhedron (comprising oxygen atoms in this case) surrounding the activator cation (cerium). It follows that the efficiency of the system may be enhanced if the excitation range of a garnet-based phosphor might be extended towards shorter wavelengths relative to a YAG:Ce phosphor.

The present disclosure will be divided into the following sections: first, a chemical description (using stoichiometric formulas) of halogenated aluminates will be given, followed by a brief description of viable synthetic methods that may be used to produce them. The structure of the halogenated aluminates will be discussed next, along with its relationship to experimental data comprising wavelength and photoluminescent changes upon the inclusion of certain halogen dopants. Finally, the role these yellow-green and yellow-emitting phosphors may play in white light illumination, general lighting, and backlighting applications will be presented with exemplary data.

### Chemical description of the present halogenated aluminate-based phosphors

The yellow to green-emitting, aluminate-based phosphors of the present invention contain both alkaline earth and halogen constituents. These dopants are used to achieve the desired photoemission intensity and spectral properties, but the fact that simultaneous alkaline earth and halogen substitutions provide a sort of self-contained charge balance is fortuitous as well. Additionally, there may be other advantageous compensations having to do with the overall changes to the size of the unit cell: while substitutions of any of Sc, La, Gd, and/or Tb for Lu (either individually, or in combinations) may tend to expand or contract the size of the cell, the opposite effect may occur with substitutions of halogen for oxygen.

There are several ways to describe the formula of green emitting phosphors.For example, a green emitting, cerium-doped, aluminate-based phosphor may be described by the formula (Lu_{1-a-b-c}YₐTb_{b}A_{c})₃(Al_{1-d}B_{d})₅(O₁₋ₑCₑ)₁₂:Ce,Eu, where A is selected from the group consisting of Mg, Sr, Ca, and Ba; B is selected from the group consisting of Ga and In; C is selected from the group consisting of F, Cl, and Br; 0≤a≤1; 0≤b≤1; 0≤c≤0.5; 0≤d≤1; and 0≤e≤0.2. The "A" element, which may be any of the alkaline earth elements Mg, Sr, Ca, and Ba, used either solely or in combination, is very effective in shifting emission wavelength to shorter values. These compounds will be referred to in the present disclosure as "halogenated LAG-based" aluminates, or simply "halogenated aluminates."

There is also described yellow to green-emitting, aluminate-based phosphors which may be described by the formula (Y,A)₃(Al,B)₅(O,C)₁₂:Ce³⁺, where A is at least one of Tb, Gd, Sm, La, Lu, Sr, Ca, and Mg, including combinations of those elements, wherein the amount of substitution of those elements for Y ranges from about 0.1 to about 100 percent in a stoichiometric manner. B is at least one of Si, Ge, B, P, and Ga, including combinations, and these elements substitute for Al in amounts ranging from about 0.1 to about 100 percent stoichiometrically. C is at least one of F, Cl, N, and S, including combinations, substituting for oxygen in amounts ranging from about 0.1 to about 100 percent stoichiometrically.

There is also described yellow to green-emitting, aluminate-based phosphors which may be described by the formula (Y₁₋ₓBaₓ)₃Al₅(O_{1-y}C_{y})₁₂:Ce³⁺, where x and y each range from about 0.001 to about 0.2.

There is also described a yellow-green to green-emitting, aluminate-based phosphor which may be described by the formula (A₁₋ₓ³⁺Bₓ²⁺)ₘAl₅(O_{1-y}²⁻C_{y}¹⁻)ₙ:Ce³⁺, where A is selected from the group consisting of Y, Sc, Gd, Tb, and Lu; B is selected from the group consisting of Mg, Sr, Ca, and Ba; C is selected from the group consisting of F, Cl, and Br; 0 ≤ x ≤ 0.5; 0 < y ≤ 0.5; 2 ≤ m ≤ 4; and 10 ≤ n ≤ 14.

There is also described a yellow-green to green-emitting, aluminate-based phosphor may be described by the formula (A₁₋ₓ³⁺Bₓ²⁺)ₘAl₅(O_{1-y}²⁻C_{y}¹⁻)n:Ce³⁺, where A is selected from the group consisting of Y, Sc, Gd, Tb, and Lu; B is selected from the group consisting of Mg, Sr, Ca, and Ba; C is selected from the group consisting of F, Cl, and Br; 0 ≤ x ≤ 0.5; 0 ≤ y ≤ 0.5; 2 ≤ m ≤ 4; and 10 ≤ n ≤ 14; subject to the proviso that m is not equal to 3.

There is also described a yellow-green to green-emitting, aluminate-based phosphor may be described by the formula (A₁₋ₓ³⁺Bₓ²⁺)ₘAl₅(O_{1-y}²⁻C_{y}¹⁻)ₙ:Ce³⁺, where A is selected from the group consisting of Y, Sc, Gd, Tb, and Lu; B is selected from the group consisting of Mg, Sr, Ca, and Ba; C is selected from the group consisting of F, Cl, and Br; 0 ≤ x ≤ 0.5; 0 ≤ y ≤ 0.5; 2 ≤ m ≤ 4; and 10 ≤ n ≤ 14; subject to the proviso that n is not equal to 12.

There is also described a yellow to green-emitting, aluminate-based phosphor may be described by the formula (Lu_{1-x-y}AₓCe_{y})₃B_{z}Al₅O₁₂C_{2z}, where A is at least one of Sc, La, Gd, and Tb; B is at least one of the alkaline earths Mg, Sr , Ca, and Ba; C is at least one of the halogen elements F, C, Br, and I; and the values of the parameters x, y, z are 0 ≤ x ≤ 0.5; 0.001 ≤ y ≤ 0.2; and 0.001 ≤ z ≤ 0.5. It is noted that "at least one of" with regard to the formulas in this disclosure means that the elements in that group may appear in the phosphor either individually, or in combinations, where any combinations of any of the elements in that group are allowable, provided that the total amount of that group satisfies the rule assigned to it in terms of overall stoichiometric amounts.

One of ordinary skill in the art will appreciate that the relationship between the amounts of C, the halogen, and B, the alkaline earth, may not always be present in the phosphor product at the expected ratio of 2:1 (stoichiometrically speaking) after a processing step such as sintering if the C and B components are added to the starting mix of materials in the form of an alkaline earth salt (e.g., B²⁺C₂). This is because the halogen component is known to be volatile, and in some instances, some of the C is lost relative to B such that the ratio of B to C in the final phosphor product is less than 2:1. Thus, the amount of C is less than 2z in the formula of paragraph [0045] by an amount of up to 5 percent by number. The amount of C is less than 2z by an amount of up to 10, 25, and 50 percent stoichiometrically.

### Synthesis

Any number of methods may be used to synthesize the present yellow-green to yellow-emitting, aluminate-based phosphors, methods that may involve both solid state reaction mechanisms as well as liquid mixing techniques. Liquid mixing includes such methods as co-precipitation and sol-gel techniques.

One embodiment of preparation involves a solid state reaction mechanism comprising the steps:
(a) desired amounts of the starting materials CeO₂, Y₂O₃, lutetium salts including the nitrates, carbonates, halides, and/or oxides of lutetium, salts of the other rare earths Sc, La, Gd, and Tb, and M²⁺X₂, where M is a divalent alkaline earth metal selected from the group consisting of Mg, Sr, Ca, and Ba, and X is a halogen selected from the group consisting of F, Cl, Br, and I were combined to form a mixture of starting powders;
(b) the mix of starting powders from step (a) is dry-mixed using any conventional method, such as ball milling, and typical mixing times using ball milling are greater than about 2 hours (in one embodiment about 8 hours);
(c) sintering the mixed starting powders from step (b) at a temperature of about 1400°C to about 1600°C for about 6 to about 12 hours in a reducing atmosphere (the purpose of this atmosphere is for a reduction of the ammonia-based compounds);
(d) crushing the sintered product from step (c), and washing it with water; and
(e) drying the washed product from step (d), wherein the drying conditions may be constitute a time of about 12 hours at a temperature of about 150°C.

The aluminates may be synthesized by liquid mixing techniques. An example of the synthesis of a *non-halogenated* LAG compound having the formula Lu_{2.985}Ce_{0.015}Al₅O₁₂ using co-precipitation has been described by H.-L. Li et al. in an article titled "Fabrication of Transparent Cerium-Doped Lutetium Aluminum Garnet Ceramics by Co-Precipitation Routes," J. Am. Ceram. Soc. 89 [7] 2356-2358 (2006). These non-halogenated LAG compounds contained no alkaline earth constituents. It is contemplated that a similar co-precipitation method may be used to produce the halogenated LAGs with alkaline earth constituents.

An example of the synthesis of a halogenated *YAG* compound using a sol-gel technique has been described in U.S. Pat. 6,013,199 by E. McFarland et al., to Symyx Technologies, titled "Phosphor materials." These (possibly) halogenated YAG compounds contained no alkaline earth constituents. It is contemplated that a similar sol-gel method may be used to produce the halogenated YAG compounds *with* alkaline earth constituents.

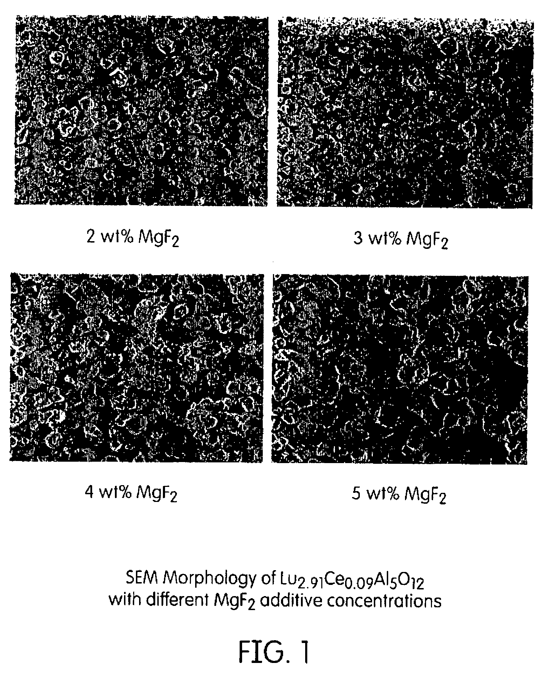

FIG. 1 shows the SEM morphology of an Lu_{2.91}Ce_{0.09}Al₅O₁₂ phosphors with different MgF₂ additive concentrations, synthesized via the solid state mechanisms described above. The morphology as revealed by scanning electron microscope (SEM) shows that particle sizes become larger, and more homogeneous, as the amount of the MgF₂ additive is increased.

### Crystal structure of the present yellow-green to yellow emitting aluminates

The crystal structure of the present yellow-green to yellow aluminates is similar to that of the yttrium aluminum garnet, Y₃Al₅O₁₂, and in keeping with this well studied YAG compound, the present aluminates may belong to the space group Ia3d (no. 230). This space group, as it pertains to YAG, has been discussed by Y. Kuru et al. in an article titled "Yttrium Aluminum Garnet as a Scavenger for Ca and Si," J. Am. Ceram. Soc. 91 [11] 3663-3667 (2008). As described by Y. Kuru et al., YAG has a complex crystal consisting of 160 atoms (8 formula units) per unit cell, where the Y³⁺ occupy positions of multiplicity 24, Wyckoff letter "c," and site symmetry 2.22, and the O²⁻ atoms occupy positions of multiplicity 96, Wyckoff letter "h," and site symmetry 1. Two of the Al³⁺ ions are situated on octahedral 16(a) positions, whereas the remaining three Al³⁺ ions are positioned on tetrahedral 24(d) sites.

The lattice parameters of the YAG unit cell are a=b=c=1.2008 nm, and α=β=γ=90°. Whereas substitution of lutetium for yttrium is expected to expand the size of the unit cell, the angles between the unit cell axes are not expected to change, and the material will retain its cubic character.

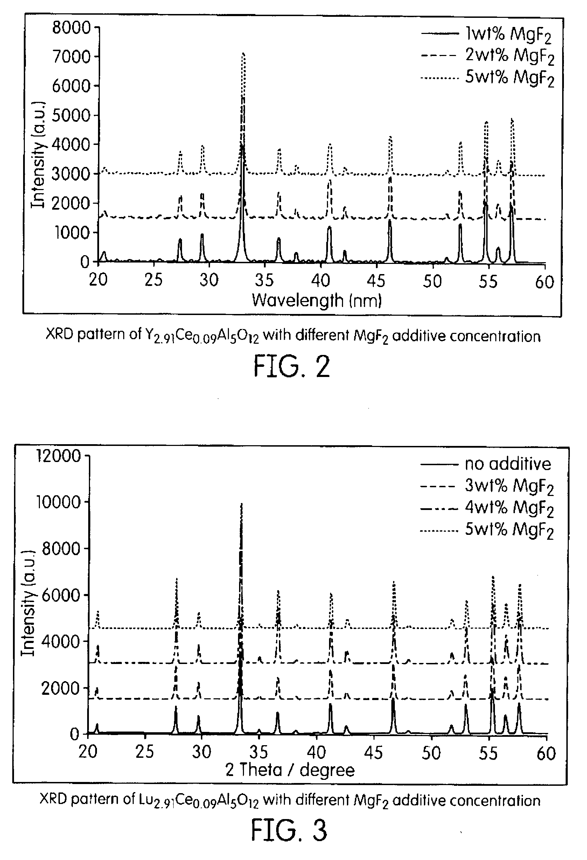

FIG. 2 shows the x-ray diffraction (XRD) patterns of a series of Y_{2.91}Ce_{0.09}Al₅O₁₂ phosphors with different MgF₂ additive concentrations, showing how the addition of an alkaline earth and a halogen (MgF₂) component shifts high angle diffraction peaks to higher values of 2θ. This means that the lattice constants become smaller relative to a YAG component with no alkaline earth/halogen, and further indicates that Mg²⁺ is being incorporated into the crystal lattice, occupying Y³⁺ positions.

FIG. 3 shows the x-ray diffraction (XRD) pattern of a series of phosphors in an analogous manner to FIG. 2, except that this time the series of compounds are Lu_{2.91}Ce_{0.09}Al₅O₁₂ phosphors with different MgF₂ additive concentrations, where lutetium-based compounds are being studied, rather than yttrium-based compounds.

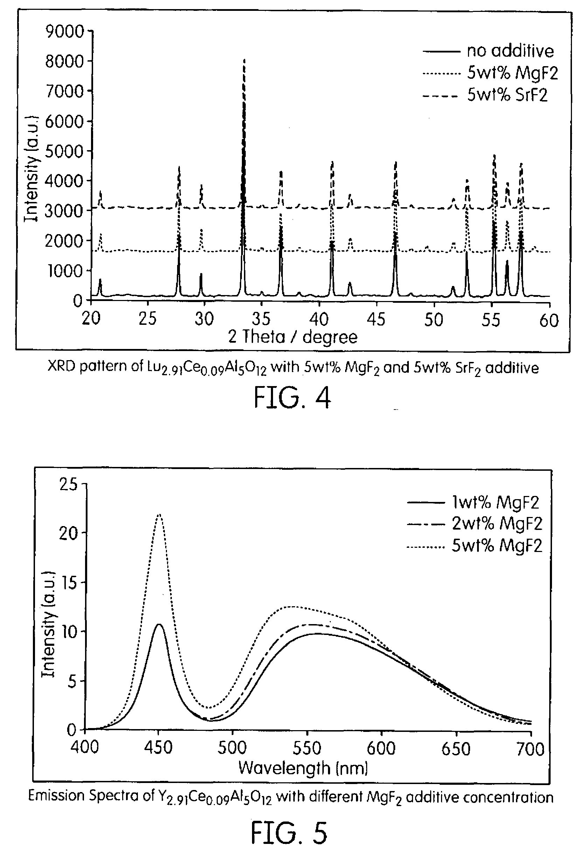

FIG. 4 shows the x-ray diffraction (XRD) pattern of a series of Lu_{2.91}Ce_{0.09}Al₅O₁₂ phosphors having either a 5 wt% MgF₂ and 5 wt% SrF₂ additive: this experiment shows a comparison of the Mg constituent versus an Sr constituent. The data shows that with the MgF₂ additive in the Lu_{2.91}Ce_{0.09}Al₅O₁₂ lattice, high angle diffraction peak move to greater values of 2θ, meaning that lattice constants become smaller. Alternatively, with SrF₂ additive, high angle diffraction peaks move to smaller values of 2θ, meaning that the lattice constants increase. It will be apparent to those skilled in the art that both Mg²⁺ and Sr²⁺ are being incorporated into the Lu_{2.91}Ce_{0.09}Al₅O₁₂ lattice and occupying Lu³⁺ positions. These peak shifts in position occur because Mg²⁺, with its ionic radius of 0.72Å, is smaller than Lu³⁺ (0.86 A), while Sr²⁺ (1.18 Å) is bigger than Lu³⁺.

### Mechanism of alkaline earth and halogen influence on optical properties

There is also described that Ce³⁺ is the luminescent activator in the aluminate-based phosphor. The transition between the 4f and 5d energy levels of the Ce³⁺ ion corresponds to excitation of the phosphor with blue light; green light emission from the phosphor is a result from the same electronic transition. In the aluminate structure, the Ce³⁺ is located at the center of an octahedral site formed by a polyanionic structure of six oxygen ions. It will be appreciated by those skilled in the art that according to crystal field theory, the surrounding anions (which may also be described as ligands) induce an electrostatic potential on the 5d electron of the central cation. The 5d energy level splitting is 1ODq, where Dq is known to depend on the particular ligand species. From the spectrochemical series it may be seen that the Dq of a halide is smaller than that of oxygen, and thus it follows that when oxygen ions are replaced by halide ions, the Dq will decrease correspondingly.

The implications of this are that the band gap energy; that is to say, the energy difference between the 4f and 5d electronic levels, will increase with substitution of oxygen ions with halide in the polyanionic cages surrounding activator ions. This is why the emission peak shifts to shorter wavelength with halogen substitution. Simultaneously, with the introduction of halide ions in the oxygen polyanionic structures forming octahedral sites, a corresponding cation may also replace a portion of the Lu (and/or Sc, La, Gd, and Tb) content. If the cation replacing Lu (and/or the other rare earths) is a smaller cation, the result will be a shift of the emission peak towards the blue end of the spectrum. The emitted luminescence will have a shorter wavelength than otherwise would have occurred. In contrast, if the cation replacing Lu is a larger cation, such as Sr or Ba, the result will be a shift of the emission peak towards the red end of the spectrum. In this case, the emitted luminescence will have a longer wavelength.

Combined with the effects of the halide, Mg as an alkaline earth substituent will be a better choice than Sr if a blue-shift is desired, and this will be shown experimentally in the following portions of the present disclosure. It is also known the LAG emission peak is a doublet due to spin-orbit coupling. As the blue-shift occurs, the emission with shorter wavelength is biased and its intensity increases correspondingly. This trend is not only helpful to the blue-shift of the emission, but also enhances photoluminescence.

FIG. 5 is the emission spectra of a series of Y_{2.91}Ce_{0.09}Al₅O₁₂ phosphors with different levels of MgF₂ additive, the emission spectra obtained by exciting the phosphors with a blue LED. This data shows that with increasing amounts of MgF₂ the photoluminescent intensity increases and the peak emission wavelength shifts to shorter values. Though not shown on FIG. 5, there is data for a 5 wt% addition of BaF₂ to the starting powders: this phosphor showed a significant increase in photoluminescent intensity relative to the three magnesium-containing phosphors, and a peak emission wavelength that the same about as that of the 1 wt% sample.

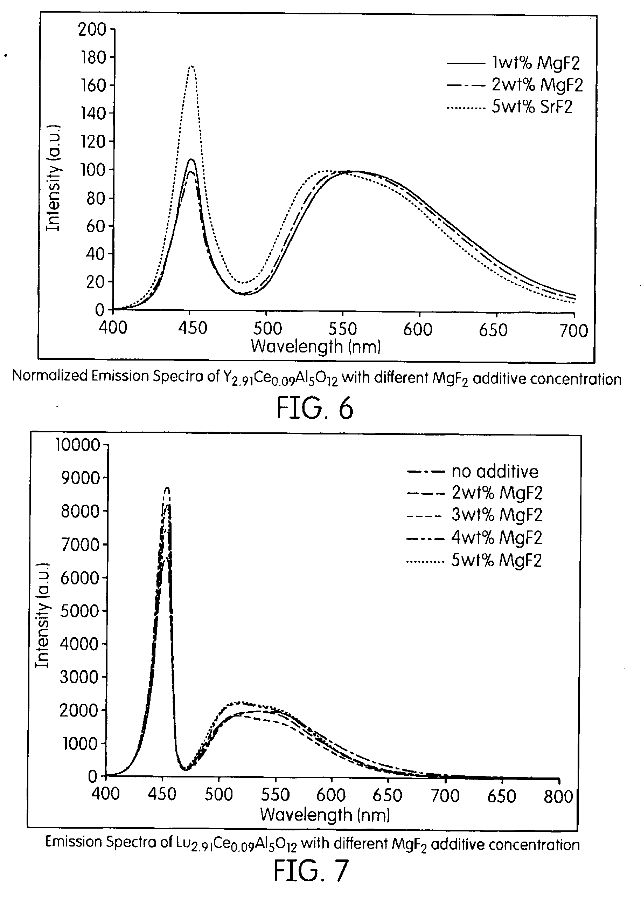

A normalized version of the data from FIG. 5 is shown in FIG. 6. FIG. 6 is the normalized emission spectra of the same series of Lu_{2.91}Ce_{0.09}Al₅O₁₂ phosphors with different MgF₂ additive concentrations under blue LED excitation, but where normalizing the photoluminescent intensity to a single value highlight that the emission peak of Y_{2.91}Ce_{0.09}Al₅O₁₂ shifts to short wavelength with increasing amounts of the MgF₂ additive. The greater the amount of the MgF₂ additive, the shorter emission peak wavelength. This is the same trend with demonstrated by a Lu_{2.91}Ce_{0.09}Al₅O₁₂ phosphor, as will be demonstrated next.

FIG. 7 is the emission spectra of a series of Lu_{2.91}Ce_{0.09}Al₅O₁₂ phosphors with different levels of MgF₂ additive, the emission spectra obtained by exciting the phosphor with a blue LED. This data is analogous to that of FIG. 5, except that lutetium-based rather than yttrium-based compounds are being studied. As with the yttrium data, this data for lutetium shows similar trends for the shift in emission wavelength, though those trends for photoluminescent intensity are not, perhaps, as similar.

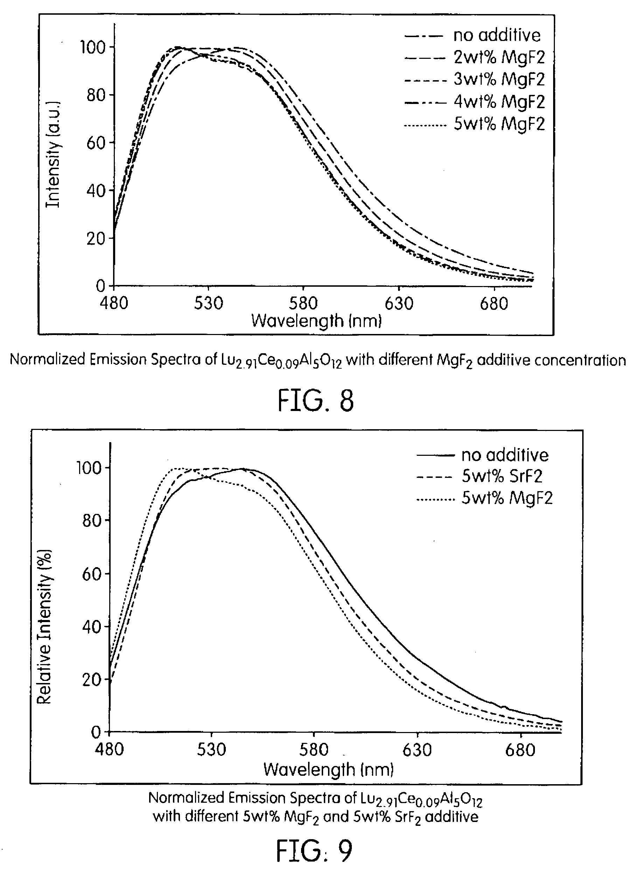

The Lu_{2.91}Ce_{0.09}Al₅O₁₂ emission spectra of FIG. 7 has been normalized to emphasize the effect of the addition of halogen salt on peak emission wavelength; the normalized version of the data is shown in FIG. 8. As in the yttrium case, peak emission shifts to shorter wavelength with increasing amounts of MgF₂ additive; that is to say, the greater the amount of the MgF₂ additive, the shorter emission peak wavelength. The amount of wavelength shift upon increasing the amount of the MgF₂ additive from zero (no additive) to about 5 wt% of the additive was observed to be about 40 nm; from about 550 nm to about 510 nm.

Each of the graphs in FIGS. 5-8 have plotted their respective spectra as a series of phosphor compositions with increasing additive concentration, starting at no additive, and ending with the highest concentration of the series at 5 wt%. To emphasize a comparison of the SrF₂ additive with the MgF₂ additive; in other words, a phosphor with an Sr alkaline earth and fluorine content with a phosphor having a Mg alkaline earth and fluorine content, the phosphors have been plotted together in FIG. 9: a phosphor with no additive, a phosphor with 5 wt% SrF₂, and a phosphor with 5 wt% MgF₂. The phosphor is based on the sample Lu_{2.91}Ce_{0.09}Al₅O₁₂

The emission spectra data in FIG. 9 has been normalized to better emphasize the effects on optical properties rendered by the inclusion the halogen and alkaline earths. When excited with a blue LED, the result illustrates that the emission peak shift to shorter wavelengths with the addition of MgF₂ and SrF₂. The Lu_{2.91}Ce_{0.09}Al₅O₁₂ sample with no additive shows a peak emission wavelength at about 550 nm; with a 5 wt% SrF₂ additive the peak emission wavelength shifts to about 535 nm, and with a 5 wt% MgF₂ additive the wavelength shifts even further to about 510 nm.

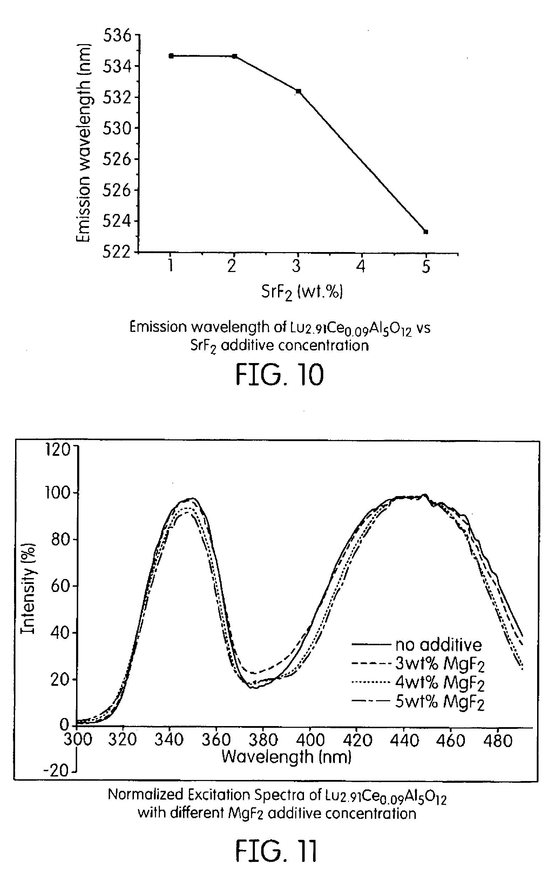

FIG. 10 shows how the emission wavelength of a series of Lu_{2.91}Ce_{0.09}Al₅O₁₂ phosphors decreases as the concentration of an SrF₂ additive is increased. Peak emission wavelength has been plotted as a function of the amount of the SrF₂ additive;
samples having an SrF₂ additive content of 1, 2, 3, and 5 wt% were tested. The results show that the peak emission wavelength was about the same for the 1 and 2 wt% samples, the wavelength being about 535 nm; as the SrF₂ additive is increased to 3 wt% the peak emission wavelength decreases to about 533 nm. With a further increase of SrF₂ additive to 5 wt% peak wavelength drops precipitously to about 524 nm.

### Excitation spectra and temperature dependence

FIG. 11 is the normalized excitation spectra of a series of Lu_{2.91}Ce_{0.09}Al₅O₁₂ phosphors with different MgF₂ additive concentrations, showing that the excitation spectra becomes more narrow when the MgF₂ additive concentration is increased. The data shows that the present green emitting, aluminate-based phosphors exhibit a wide band of wavelengths over which the phosphors may be excited, ranging from about 380 to about 480 nm.

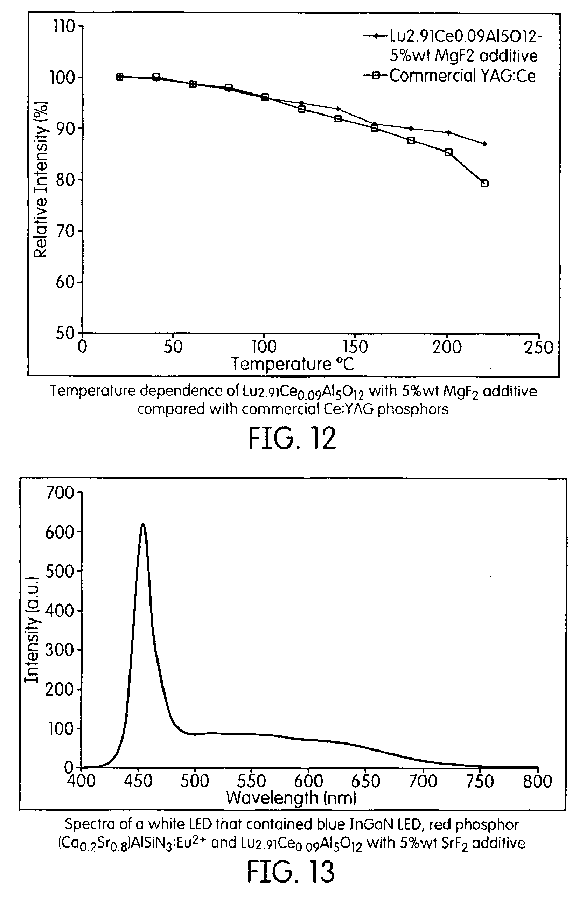

The thermal stability of the garnet phosphors is shown by the lutetium containing compound Lu_{2.91}Ce_{0.09}Al₅O₁₂ with a 5wt% MgF₂ additive; its thermal stability is compared with the commercially available phosphor Ce³⁺:Y₃Al₅O₁₂ in FIG. 12. It may be observed that the thermal stability of the Lu_{2.91}Ce_{0.09}Al₅O₁₂ compound is even better than the YAG.

### Applications to backlighting and white light illumination systems

There is also described that the green emitting, aluminate-based phosphors may be used in white light illumination systems, commonly known as "white LEDs," and in backlighting configurations for display applications. Such white light illumination systems comprise a radiation source configured to emit radiation having a wavelength greater than about 280 nm; and a halide anion-doped green aluminate phosphor configured to absorb at least a portion of the radiation from the radiation source, and emit light having a peak wavelength ranging from 480 nm to about 650 nm.

FIG. 13 shows the spectra of a white LED that includes an green-emitting, aluminate-based phosphor having the formula Lu_{2.91}Ce_{0.09}Al₅O₁₂ with a 5 wt% SrF₂ additive. This white LED further includes a red phosphor having the formula (Ca_{0.2}Sr_{0.8})AlSiN₃:Eu²⁺. When both green aluminate and red nitride phosphors are excited with an InGaN LED emitting blue light, the resulting white light displayed the color coordinates CIE x = 0.24, and CIE y = 0.20.

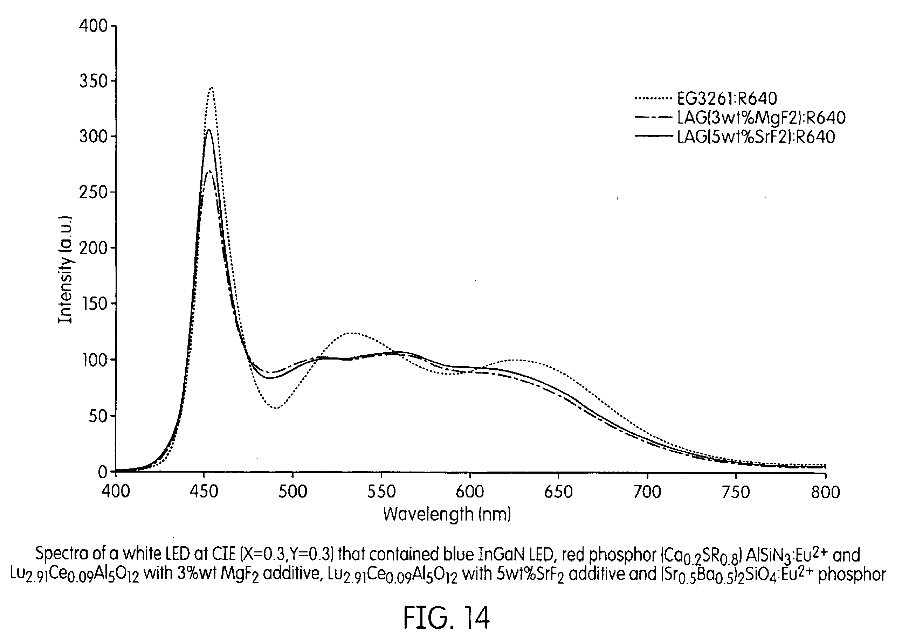

FIG. 14 is the spectra of a white LED with the following components: a blue InGaN LED, a green garnet having the formula Lu_{2.91}Ce_{0.09}Al₅O₁₂ with either 3 or 5 wt% additives, a red nitride having the formula (Ca_{0.2}Sr_{0.08})AlSiN₃:Eu²⁺ or a silicate having the formula (Sr_{0.5}Ba_{0.5})2SiO₄:Eu²⁺, wherein the white light has the color coordinates CIE (x=0.3, y=0.3). The sample that shows the most prominent double peak is the one labeled "EG3261 + R640," where the EG3261 designation represents the (Sr_{0.5}Ba_{0.5})₂SiO₄:Eu²⁺ phosphor, in combination with the red R640 (Ca_{0.2}Sr_{0.8})AlSiN₃:Eu²⁺ phosphor emitting at about 640 nm. The two peaks labeled LAG (3 wt% MgF₂) + R640 and LAG (5 wt% SrF₂) + R640 demonstrate a much more uniform emission of perceived white light over the wavelength range 500 to 650 nm, an attribute desirable in the art.

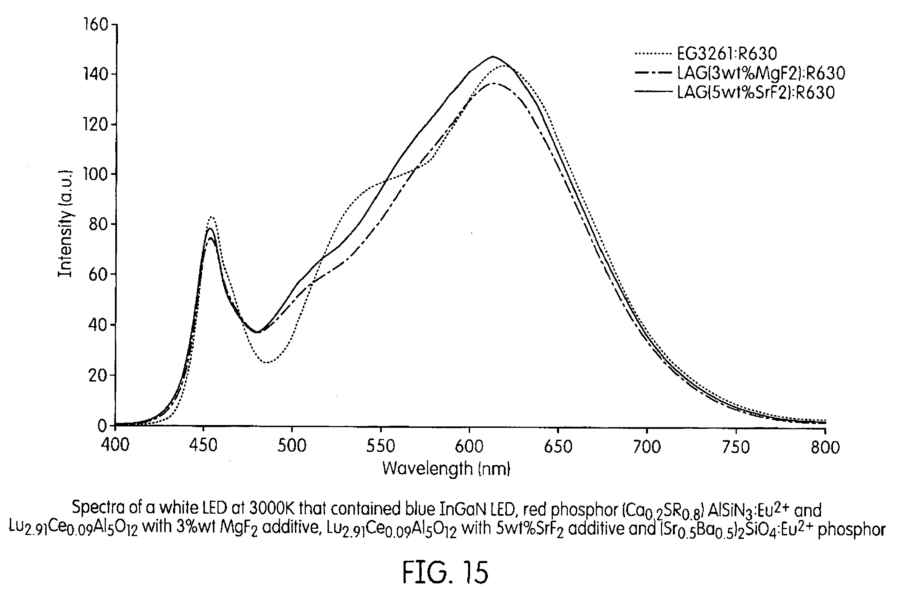

FIG. 15 is the spectra of the white LED systems of FIG 14, in this instance measured at 3,000 K.

There is also described that the red nitride that may be used in conjunction with the green aluminate may have the general formula (Ca,Sr)AlSiN₃:Eu²⁺, where the red nitride may further comprise an optional halogen, and wherein the oxygen impurity content of the red nitride phosphor may be less than equal to about 2 percent by weight. The yellow-green silicates may have the general formula (Mg,Sr,Ca,Ba)₂SiO₄:Eu²⁺, where the alkaline earths may appear in the compound either individually, or in any combination, and wherein the phosphor may be halogenated by F, Cl, Br, or I (again, either individually, or in any combination).

### Optical and physical data in table form

A summary of data is tabulated in the two tables at the end of this specification. In Table 1 is the testing results of a Lu_{2.91}Ce_{0.09}Al₅O₁₂ based phosphor with three different MgF₂ additive levels. Table 2 tabulates the testing results of a Lu_{2.91}Ce_{0.09}Al₅O₁₂ based compound with four different SrF₂ additive. These results summarize and confirm that MgF₂ and SrF₂ additives in Lu_{2.91}Ce_{0.09}Al₅O₁₂ shift the emission peak wavelength to shorter wavelengths, where the emission intensity is increased with increasing MgF₂ and SrF₂ concentration. The particle size also increases with the increasing MgF₂ and SrF₂ additive concentration.

### Yellow-green to yellow emitting, rare earth doped aluminate-based phosphors

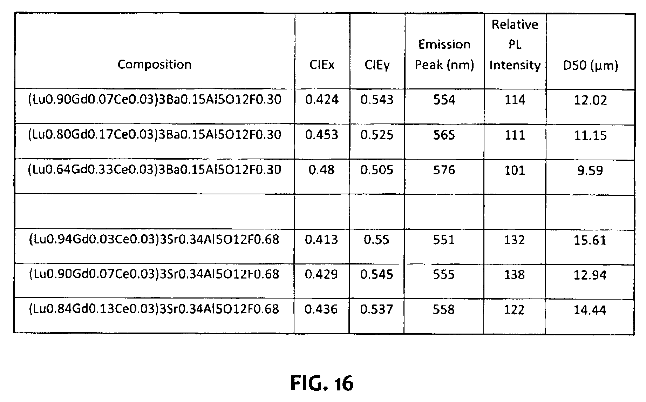

The rare earth doping of a specific series of yellow-green to yellow emitting, halogenated aluminates were tested by the present inventors, where the phosphors had the general formula (Lu_{1-x-y}AₓCe_{y})₃B_{z}Al₅O₁₂C_{2z}. As disclosed above, A is Gd; B is at least one of the alkaline earths Sr and Ba; C is at least one of the halogen elements F, C, Br, and I; and the values of the parameters x, y, z are 0 ≤ x ≤ 0.5; 0.001 ≤ y ≤ 0.2; and 0.001 ≤ z ≤ 0.5. In this series of phosphors, the rare earth dopant was Gd, and the alkaline earth was either Ba or Sr. The halogen was F in all of the compounds tested in this series of experiments. The formulas of the specific aluminates tested are shown in FIG. 16.

For the purpose of this disclosure, a green emission will be defined as having a peak emission wavelength of from about 500 nm to about 550 nm. Emissions extending from about 550 nm to about 600 nm may be described as containing wavelengths that change from a yellow-green color to a yellow color. The addition of Gd doping converts the phosphor from a substantially green-emitting sample to a substantially yellow sample in the experiments described; though not shown, increasing the Gd concentration even further (from about 0.33 for Ba samples and from about 0.13 for Sr samples) shifts the emission further towards and into the yellow region of the electromagnetic spectrum. Making generalizations can be difficult because the peak emission wavelength depends not only on the choice and level of the rare earth(s) dopants present in addition to lutetium (e.g., Gd in addition to Lu), but also on the selection and amounts of the included alkaline earth(s) and the halogen(s). The halogenated aluminates in the present disclosure are defined to emit in the yellow-green to the yellow region of the electromagnetic spectrum, at wavelengths from about 550 nm to about 600 nm. Green-emitting halogenated aluminates emit at peak wavelengths ranging substantially from about 500 nm to about 550 nm. For green-emitting aluminates, see US. Publication No. 2012/0112130 filed July 12, 2011, assigned to the same assignee as the present application.

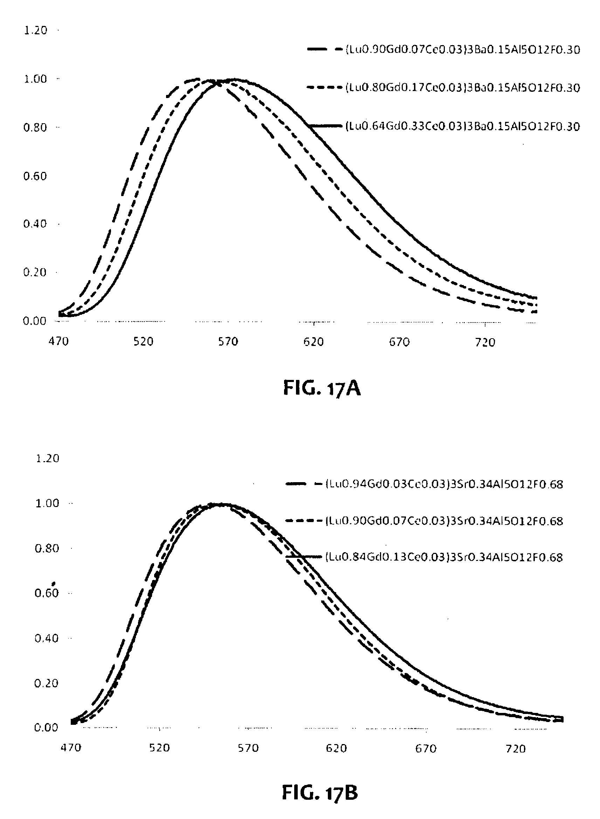

The data in FIGS. 16 and 17A-B shows that the peak emission wavelength of these halogenated aluminates ranged overall from about 550 nm to about 580 nm as the Gd level was increased, where the Ba level was fixed stoichiometrically at 0.15 for the Ba series, and where the Sr level was fixed stoichiometrically at 0.34 for the Sr series (the concentration is stoichiometric, meaning by number, not by weight). The Ce activator level was also fixed stoichiometrically at 0.03 for all of the samples. Specifically, for the Ba samples, the peak emission wavelength increased from 554 nm to 565 nm to 576 nm as the Gd amount was increased stoichiometrically from 0.07 to 0.17 to 0.33, respectively. For the Sr samples, the peak emission wavelength increased from 551 nm to 555 nm to 558 nm as the Gd amount was increased stoichiometrically from 0.03 to 0.07 to 0.13, respectively.

The actual compounds in the Ba series were, respectively, (Lu_{0.90}Gd_{0.07}Ce_{0.03})₃Ba_{0.15}Al₅O₁₂F_{0.30}, (Lu_{0.80}Gd_{0.17}Ce_{0.03})₃Ba_{0.15}Al₅O₁₂F_{0.30}, and (Lu_{0.64}Gd_{0.33}Ce_{0.03})₃Ba_{0.15}Al₅O₁₂F_{0.30}. The actual compounds tested in the Sr series were, respectively, (Lu_{0.94}Gd_{0.03}Ce_{0.03})₃Sr_{0.34}Al₅O₁₂F_{0.68}, (Lu_{0.90}Gd_{0.07}Ce_{0.03})₃Sr_{0.34}Al₅O₁₂F_{0.68}, and (Lu_{0.84}Gd_{0.13}Ce_{0.03})₃Sr_{0.34}Al₅O₁₂F_{0.68}.

It is noted that the Sr series emitted at a higher relative photoluminescent intensity when compared to the Ba series, but one skilled in the art will know to draw conclusions carefully, as several other variables were changed at the same time (e.g., Gd content, alkaline earth amounts, and halogen concentrations).

Shown in FIGS. 16A-B are the x-ray diffraction patterns of both the Ba series and the Sr series of phosphors whose luminosity data was depicted in FIGS. 17A-B.

**Table 1. Testing results of Lu_{2.91}Ce_{0.09}Al₅O₁₂ with different MgF₂ levels of additive**

| MgF₂ (wt%) | CIE x | CIE y | Emission Peak Wavelength (nm) | Relative Intensity (%) | Particle Size D50 (run) |
|---|---|---|---|---|---|
| 1 | 0.3635 | 0.5862 | 526.88 | 58.04 | 4.01 |
| 2 | 0.3554 | 0.5778 | 529.56 | 78.47 | 7.38 |
| 3 | 0.3336 | 0.5776 | 514.22 | 105.13 | 9.30 |

**Table 2 Testing results of Lu_{2.91}Ce_{0.09}Al₅O₁₂ with different levels of SrF₂ additive**

| SrF₂ (wt%) | CIE x | CIE y | Emission Peak Wavelength (nm) | Relative Intensity (%) | Particle Size D50 (run) |
|---|---|---|---|---|---|
| 1 | 0.3677 | 0.5732 | 534.64 | 71.65 | 3.84 |
| 2 | 0.3677 | 0.5732 | 534.64 | 85.82 | 5.24 |
| 3 | 0.3555 | 05718 | 532.43 | 112.40 | 9.90 |
| 5 | 0.3405 | 0.5748 | 523.44 | 107.67 | 11.38 |

## Claims

1. A yellow-green to yellow-emitting halogenated lutetium aluminate phosphor having the formula: (Lu_{1-x-y}AₓCe_{y})₃B_{z}Al₅O₁₂C_{2z}; where
A is Gd;
B is at least one of Sr and Ba;
C is at least one of F, Cl, Br, and I;
0 < x ≤ 0.5; 0.001 ≤ y ≤ 0.2; and 0.001 ≤ z ≤ 0.5;
wherein said phosphor is configured to emit light having a peak emission wavelength ranging from 550 nm to 600 nm.

2. The yellow-green to yellow-emitting halogenated lutetium aluminate phosphor of claim 1, wherein C is F.

3. The yellow-green to yellow-emitting halogenated lutetium aluminate phosphor of claim 2, wherein 0.03 ≤ x ≤ 0.13 and B is Sr.

4. The yellow-green to yellow-emitting halogenated lutetium aluminate phosphor of claim 3, wherein said yellow-green to yellow-emitting halogenated aluminate phosphor is selected from the group consisting of:
(Lu_{0.94}Gd_{0.03}Ce_{0.03})₃Sr_{0.34}Al₅O₁₂F_{0.68};
(Lu_{.090}Gd_{0.07}Ce_{0.03})₃Sr_{0.034}Al₅O₁₂F_{0.68}; and
(Lu_{0.84}Gd_{0.13}Ce_{0.03})₃Sr_{0.34}Al₅O₁₂F_{0.68}.

5. The yellow-green to yellow-emitting halogenated lutetium aluminate phosphor of claim 2, wherein 0.07 ≤ x ≤ 0.33 and B is Ba.

6. The yellow-green to yellow-emitting halogenated lutetium aluminate phosphor of claim 5, wherein said yellow-green to yellow-emitting halogenated aluminate phosphor is selected from the group consisting of:
(Lu_{0.90}Gd_{0.07}Ce_{0.03})₃Ba_{0.15}Al₅O₁₂F_{0.30};
(Lu_{0.080}Gd_{0.17}Ce_{0.03})₃Ba_{0.15}Al₅O₁₂F_{0.30}; and
(Lu_{0.64}Gd_{0.33}Ce_{0.03})₃Ba_{0.15}Al₅O₁₂F_{0.30}.

7. The yellow-green to yellow-emitting halogenated lutetium aluminate phosphor of claim 1, wherein the phosphor is configured to absorb excitation radiation having a wavelength ranging from 380 nm to 480 nm.

8. A white LED comprising: a radiation source configured to provide radiation having a wavelength greater than 280 nm;
a cerium-activated, yellow-green to yellow-emitting halogenated lutetium aluminate phosphor according to any of claims 1 to 7; and
at least one of a red-emitting phosphor or a yellow-emitting phosphor.

9. The white LED of claim 8, wherein the red-emitting phosphor is a nitride.

10. The white LED of claim 9, wherein the nitride has the formula (Ca,Sr)AlSiN₃:Eu²⁺.

11. The white LED of claim 8, wherein the yellow-emitting phosphor is a silicate.

12. The white LED of claim 11, wherein the silicate has the formula (Sr,Ba)₂SiO₄:Eu²⁺.

## Patentansprüche

1. Gelb-grün bis gelb emittierender halogenierter Lutetiumaluminat-Leuchtstoff mit der Formel: (Lu_{1-x-y}A₅Ce_{y})₃B_{Z}Al₅O₁₂C_{2z}; wobei
A für Gd steht;
B für mindestens eines aus Sr und Ba steht;
C für mindestens eines aus F, Cl, Br und I steht;
0 < ≤ 0,5; 0,001 ≤ y ≤ 0,2; und ≤ z ≤ 0,5;
wobei der Leuchtstoff konfiguriert ist, um Licht mit einer Peak-Wellenlänge im Bereich von 550 nm bis 600 nm zu emittieren.

2. Gelb-grün bis gelb emittierender halogenierter Lutetiumaluminat-Leuchtstoff nach Anspruch 1, wobei C für F steht.

3. Gelb-grün bis gelb emittierender halogenierter Lutetiumaluminat-Leuchtstoff nach Anspruch 2, wobei 0,03 x ≤ 0,13 und B für Sr steht.

4. Gelb-grün bis gelb emittierender halogenierter Lutetiumaluminat-Leuchtstoff nach Anspruch 3, wobei der gelb-grün bis gelb emittierende halogenierte Lutetiumaluminat-Leuchtstoff ausgewählt ist aus der Gruppe, bestehend aus:
(LU_{0.094}Gd_{0.03}Ce_{0.03})₃Sr_{0.34}Al₅O₁₂F0.68;
(Lu_{0.90}Gd_{0.07}Ce_{0.03})₃Sr_{0.34}Al₅O₁₂F_{0.68}; und
(LU_{0.84}Gd_{0.13}Ce_{0.03})₃Sr_{0.34}Al₅O₁₂F_{0.68}.

5. Gelb-grün bis gelb emittierender halogenierter Lutetiumaluminat-Leuchtstoff nach Anspruch 2, wobei 0,07 ≤ x ≤ 0,33 und B für Ba steht.

6. Gelb-grün bis gelb emittierender halogenierter Lutetiumaluminat-Leuchtstoff nach Anspruch 5, wobei der gelb-grün bis gelb emittierende halogenierte Lutetiumaluminat-Leuchtstoff ausgewählt ist aus der Gruppe, bestehend aus:
(Lu_{0.90}Gd_{0.07}Ce_{0.0}3)3Ba_{0.15}Al₅O₁₂F_{0.30};
(Lu_{0.80}Gd_{0.17}Ce_{0.03})₃Ba_{0.15}Al₅O₁₂F_{0.30}; und
(Lu_{0.64}Gd₀.₃₃Ce₀.₀₃)₃Ba_{0.15}Al₅O₁₂F_{0.30}.

7. Gelb-grün bis gelb emittierender halogenierter Lutetiumaluminat-Leuchtstoff nach Anspruch 1, wobei der Leuchtstoff konfiguriert ist, um Anregungsstrahlung mit einer Wellenlänge im Bereich von 380 nm bis 480 nm zu absorbieren.

8. Weiße LED, umfassend: eine Strahlungsquelle, die konfiguriert ist, um Strahlung mit einer Wellenlänge von über 280 nm bereitzustellen;
einen mit Cerium aktivierten, gelb-grün bis gelb emittierenden halogenierten Lutetiumaluminat-Leuchtstoff nach einem der Ansprüche 1 bis 7; und
mindestens eines aus einem rot emittierenden Leuchtstoff oder einem gelb emittierenden Leuchtstoff.

9. Weiße LED nach Anspruch 8, wobei der rot emittierende Leuchtstoff ein Nitrid ist.

10. Weiße LED nach Anspruch 9, wobei das Nitrid die Formel (Ca,Sr)A1SiN₃:Eu²⁺ aufweist.

11. Weiße LED nach Anspruch 8, wobei der gelb emittierende Leuchtstoff ein Silikat ist.

12. Weiße LED nach Anspruch 11, wobei das Silikat die Formel (Sr,Ba)₂SiO₄:Eu²⁺ aufweist.

## Revendications

1. Luminophore d'aluminate de lutécium halogéné émettant de la lumière jaune-vert à jaune, de formule : (Lu_{i-x-y}AₓCe_{y})₃B_{z}Al₅O₁₂C_{2z} ; où
A est Gd ;
B est au moins l'un parmi Sr et Ba ;
C est au moins l'un parmi F, CI, Br et I ;
0 < x ≤ 0,5 ; 0,001 ≤ y ≤ 0,2 ; et 0,001 ≤ z ≤ 0,5 ;
où ledit luminophore est conçu pour émettre de la lumière possédant une longueur d'onde d'émission de pic allant de 550 nm à 600 nm.

2. Luminophore d'aluminate de lutécium halogéné émettant de la lumière jaune-vert à jaune selon la revendication 1, dans lequel C est F.

3. Luminophore d'aluminate de lutécium halogéné émettant de la lumière jaune-vert à jaune selon la revendication 2, dans lequel 0,03 ≤ x ≤ 0,13 et B est Sr.

4. Luminophore d'aluminate de lutécium halogéné émettant de la lumière jaune-vert à jaune selon la revendication 3, où ledit luminophore d'aluminate halogéné émettant de la lumière jaune-vert à jaune est choisi dans le groupe constitué de :
(Lu_{0,90}Gd_{0,30}Ce_{0,03})₃Sr_{0,03}Al₅O₁₂F_{0,68} ;
(Lu_{0,90}Gd_{0,07}Ce_{0,03})₃Sr_{0,34}Al₅O₁₂F_{0,68} ; et
(Lu₀,₈₄Gd_{0,13}Ce_{0,03})₃Sr_{0,34}Al₅O₁₂F_{0,68}.

5. Luminophore d'aluminate de lutécium halogéné émettant de la lumière jaune-vert à jaune selon la revendication 2, dans lequel 0,07 ≤ x ≤ 0,33 et B est Ba.

6. Luminophore d'aluminate de lutécium halogéné émettant de la lumière jaune-vert à jaune selon la revendication 5, où ledit luminophore d'aluminate halogéné émettant de la lumière jaune-vert à jaune est choisi dans le groupe constitué de :
(Lu_{0,90}Gd_{0,07}We_{0,03})₃Ba_{0,15}Al₅O₁₂F_{0,30};
(Lu_{0,80}Gd_{0,17}Ce_{0,03})₃Ba_{0,15}Al₅O₁₂F_{0,30} ; et
(Lu₀,₆₄Gd_{0,33}Ce_{0,03})₃Ba_{0,15}Al₅O₁₂F_{0,30}.

7. Luminophore d'aluminate de lutécium halogéné émettant de la lumière jaune-vert à jaune selon la revendication 1, où le luminophore est conçu pour absorber un rayonnement d'excitation possédant une longueur d'onde allant de 380 nm à 480 nm.

8. DEL blanche comprenant : une source de rayonnement conçue pour fournir un rayonnement possédant une longueur d'onde supérieure à 280 nm ;
un luminophore d'aluminate de lutécium halogéné émettant de la lumière jaune-vert à jaune activé au cérium selon l'une quelconque des revendications 1 à 7 ; et
au moins l'un parmi un luminophore émettant de la lumière rouge ou un luminophore émettant de la lumière jaune.

9. DEL blanche selon la revendication 8, dans laquelle le luminophore émettant de la lumière rouge est un nitrure.

10. DEL blanche selon la revendication 9, dans laquelle le nitrure est de formule (Ca,Sr)AlSiN₃:Eu²⁺.

11. DEL blanche selon la revendication 8, dans laquelle le luminophore émettant de la lumière jaune est un silicate.

12. DEL blanche selon la revendication 11, dans laquelle le silicate est de formule (Sr,Ba)₂SiO₄:Eu²⁺
